# EUROPÄISCHE PATENTSCHRIFT

(11) **EP 0 986 137 B1**
(45) Veröffentlichungstag und Bekanntmachung des Hinweises auf die Patenterteilung: **05.02.2003**
(21) Anmeldenummer: 99113441.2
(22) Anmeldetag: 10.07.1999
(51) Int. Cl.: H01R 12/04, H01R 12/18, H01R 12/36, H05K 13/04, H01R 43/20, H01R 12/22, H01R 12/02, H01R 12/32

(54) **Steckerleiste für die Oberflächenmontage auf einer Leiterplatte**
Contact strip for surface mounting on a printed circuit board
Barrette de connexion pour montage en surface sur un circuit imprimé

(30) Priorität: 20.08.1998 DE 29814935 U
(43) Veröffentlichungstag der Anmeldung: 15.03.2000
(73) Patentinhaber: ROBERT BOSCH GMBH, 70442 Stuttgart (DE)
(72) Erfinder: Jelinek, Egbert, 31157 Sarstedt (AT)

(56) Entgegenhaltungen:
- US-A- 3 807 045
- US-A- 5 242 311
- US-A- 5 361 492
- US-A- 5 681 174

## Beschreibung

### Stand der Technik

Die Erfindung geht aus von einer Steckerleiste für die SMD-Oberflächenmontage auf einer Leiterplatte. Durch die DE 35 44 125 C2 ist eine gattungsgemäße Steckerleiste bekannt.

Bei der SMD-Oberflächenmontage, wobei SMD für Surface Mounted Device steht, werden auf Leiterplatten Bauelemente ein- oder zweiseitig aufgesetzt und direkt auf der Oberfläche der Leiterplatte befestigt. Während die üblicherweise sehr kleinen elektronischen Bauelemente beim Aufbringen keine Schwierigkeiten aufwerfen, gibt es bei größeren Bauelementen wie Steckerleisten mitunter mechanische Probleme, so daß die erforderliche Vorjustierung der Bauelemente auf der Leiterplatte über von der SMD-Montagetechnik unabhängige, also separaten Befestigungselemente, wie Winkel mit Schraubanschlüssen, erfolgt.

Damit ist der Fertigungsvorteil der SMD-Montagetechnik, der auf vollautomatischer Bestückung und Fertigstellung der bestückten Leiterplatten durch spezielle Lötverfahren beruht, nicht mehr in vollem Umfang gegeben. Mit der Zuführung der Leiterplatte von einer vollautomatischen Fertigungsstraße zu einer Handbestückungsstation werden die Herstellungskosten der Leiterplatte durch die separate Montage der Steckerleiste in unerwünschter Weise kostenintensiv.

Weiterhin ist durch die US-A-3 807 045 eine Steckerleiste zur Montage auf einer Leiterplatte bekannt. Mittels eines mit der Steckerleiste verbundenen Trägerelements in Form eines Transportbandes als Handhabungskörper der Steckerleiste kann eine aufklappbare, zangenförmige Bestückungsvorrichtung die Steckerleiste erfassen und auf einer Leiterplatte korrekt ausrichten. Danach wird das Transportband von der Steckerleiste entfernt.

### Vorteile der Erfindung

Die erfindungsgemäße Steckerleiste für die Oberflächenmontage auf einer Leiterplatte mit den kennzeichnenden Merkmalen des Anspruchs 1 hat gegenüber dem eingangs genannten Stand der Technik den Vorteil, daß die zuvor erwähnte Unzulänglichkeit in zufriedenstellendem Maß vermieden wird.

Dazu ist die Steckerleiste mit einem Handhabungskörper versehen, mit dessen Hilfe die Steckerleiste durch eine Bestückungsvorrichtung der Leiterplatte in automatisierter Form zugeführt und ausgerichtet auf der Oberfläche abgesetzt wird. Durch einen mit der Steckerleiste koppelbaren Gegenstecker, der eine zu dem Handhabungskörper korrespondierende Andrückfläche aufweist, wird der Handhabungskörper von einer Erfassungsposition in eine Rastposition am Kontaktträger verlagert. Mit einer solchermaßen ausgebildeten Steckerleiste läßt sich ohne eine Werkzeugänderung bei der Herstellung der Steckerleiste diese in der SMD-Montagetechnik auf der Leiterplatte anbringen und die so bestückte Leiterplatte in automatischer Produktion kostengünstig fertigen.

Durch die in den Unteransprüchen aufgeführten Maßnahmen sind vorteilhafte Weiterbildungen der im Anspruch 1 angegebenen Steckerleiste möglich.

### Zeichnung

Zwei Ausführungsbeispiele der Erfindung sind in der Zeichnung schematisiert dargestellt und in der nachfolgenden Beschreibung näher erläutert. Das erste Ausführungsbeispiel ist in den Figuren 1 bis 4 und das zweite Ausführungsbeispiel in den Figuren 5 bis 8 dargestellt. Es zeigen:
Figur 1 eine Schnittdarstellung einer Steckerleiste mit einem Handhabungskörper entlang der Linie I-I in Figur 2 mit einer zusätzlichen Leiterplatte,
Figur 2 eine Seitenansicht der Steckerleiste mit dem Handhabungskörper im Schnitt,
Figur 3 eine Schnittdarstellung wie in Figur 1, jedoch mit einem auf die Steckerleiste aufgeschobenen Gegenstecker,
Figur 4 eine Draufsicht auf die Steckerleiste mit in eine Rastposition verlagerten Handhabungsteil ohne den Gegenstecker,
Figur 5 eine Schnittdarstellung der Steckerleiste sowie dem Handhabungskörper entlang der Linie V-V in Figur 6 und mit einer zusätzlichen Leiterplatte,
Figur 6 eine Draufsicht auf die Steckerleiste,
Figur 7 eine Schnittdarstellung wie in der Figur 5, jedoch mit einem auf die Steckerleiste aufgeschobenen Gegenstecker,
Figur 8 eine Seitenansicht der Steckerleiste mit in die Rastposition verschobenem Handhabungskörper und aufgeschobenem Gegenstecker.

### Beschreibung der Ausführungsbeispiele

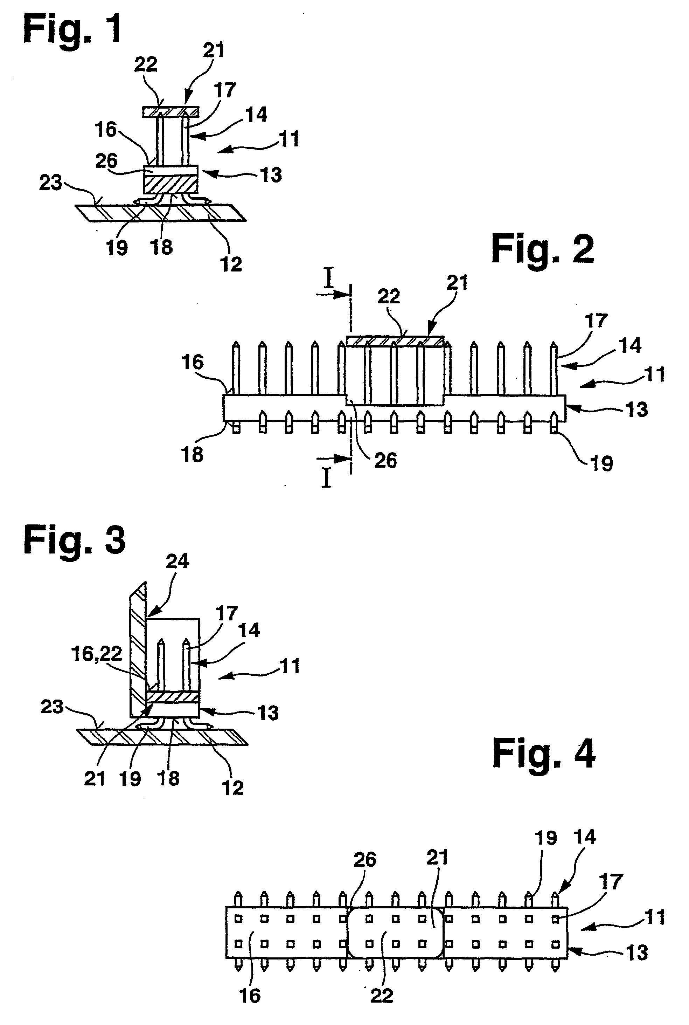

Eine Steckerleiste 11 für die Oberflächenmontage auf einer Leiterplatte 12 nach der Figur 1 besteht im wesentlichen aus einem quaderförmigen Kontaktträger 13 aus elektrisch isolierendem Kunststoff und aus einer Vielzahl von Kontaktelementen 14.

Die Kontaktelemente 14 sind über eine Teillänge in dem Kontaktträger 12 eingebettet und gehalten. Die mehrreihig angeordneten Kontaktelemente 14 ragen jeweils lotrecht endseitig aus dem Kontaktträger 13 heraus, zum einen, an einer Vorderseite des Kontaktträgers 13 mit einem Kontaktabschnitt 17 und zum anderen, an einer zu der Vorderseite 16 parallel versetzten Rückseite 18 des Kontaktträgers 13, mit einem Anschlußabschnitt 19.

Der Anschlußabschnitt 19 verläuft, beginnend mit dem Austritt des Kontaktelements 14 aus der Rückseite 18, rechtwinklig abgebogen parallel zur Rückseite 18. Alle Anschlußabschnitte 19 der Kontaktelemente 14 zusammen, bilden die Aufstandsfläche der Steckerleiste 11 auf der Leiterplatte 12.

Die Kontaktabschnitte 17, die beim ersten Ausführungsbeispiel freistehend sind, sind, wie in der Figur 2 verdeutlicht, teilweise mit einem Handhabungskörper 21 belegt. Bei diesem Ausführungsbeispiel ist der Handhabungskörper 21 durch eine dünne Kunststoffplatte verwirklicht und auf die zugeordneten Kontaktabschnitte 17 geklemmt oder geklebt. Diese Fixierung an den Kontaktabschnitten 17 erfolgt so, daß eine von dem Kontaktträger 13 abgewandte ebene Erfassungsfläche 22 von den zugespitzten Kontaktabschnitten 17 noch nicht durchstoßen ist und die Steckerleiste 11 an der Erfassungsfläche 22 von einer handelsüblichen Bestückungsmaschine, insbesondere durch Unterdruckansaugung, erfaßt werden kann.

Eine so von der Bestückungsmaschine aufgenommene Steckerleiste 11 wird aus einem Magazin, beispielsweise einem Gurt, entnommen und mit den Anschlußabschnitten 19 auf zugeordnete Anschlüsse an einer Oberseite 23 der Leiterplatte 12 abgesetzt. Die hier nicht mehr dargestellten Anschlüsse für die Anschlußabschnitte 19 sind entsprechend der SMD-Oberflächenmontage im Siebdruckverfahren durch dickschichtigen Lotauftrag in Pastenform gebildet.

Die mit der Steckerleiste 11 bestückte Leiterplatte 12 wird in einem mit einer Wärmequelle, beispielsweise einer Rotlichtlampe ausgerüsteten Reflow-Ofen einer das Lot ausschmelzenden Wärmebehandlung unterzogen, so daß Lötverbindungen zwischen den Anschlüssen und den Anschlußabschnitten 19 der Steckerleiste 11 entstehen. Durch diese stoffschlüssige Verankerung der Anschlußabschnitte 19 an den Anschlüssen ist die Steckerleiste 11 stabil auf der Leiterplatte 12 verankert und zur Aufnahme eines Gegensteckers 24 vorbereitet.

Der in der Figur 3 schematisch dargestellte Gegenstecker 24 drückt beim Aufstecken auf die Steckerleiste 11 unter einer erhöhten Anfangssteckkraft den Handhabungskörper 21 vollends durch die freiliegenden Enden der Kontaktabschnitte 17 und im Zuge einer weitergeführten Einsteckbewegung an den Kontaktabschnitten 17 entlang bis zu einer in der Figur 2 ersichtlichen Vertiefung 26 an der Vorderseite 16 des Kontaktträgers 13.

Bei beendetem Aufsteckvorgang mit dem Anschlag des Gegensteckers 24 an der Vorderseite 16 des Kontaktträgers 13 schließt die Oberseite 23 des Handhabungskörpers 21 dann, wie in den Figuren 3 und 4 dargestellt, bündig mit der Vorderseite 16 des Kontaktträgers 13 ab, so daß die Kontaktgabe zwischen Steckerleiste 11 und Gegenstecker 24 nicht beeinträchtigt ist.

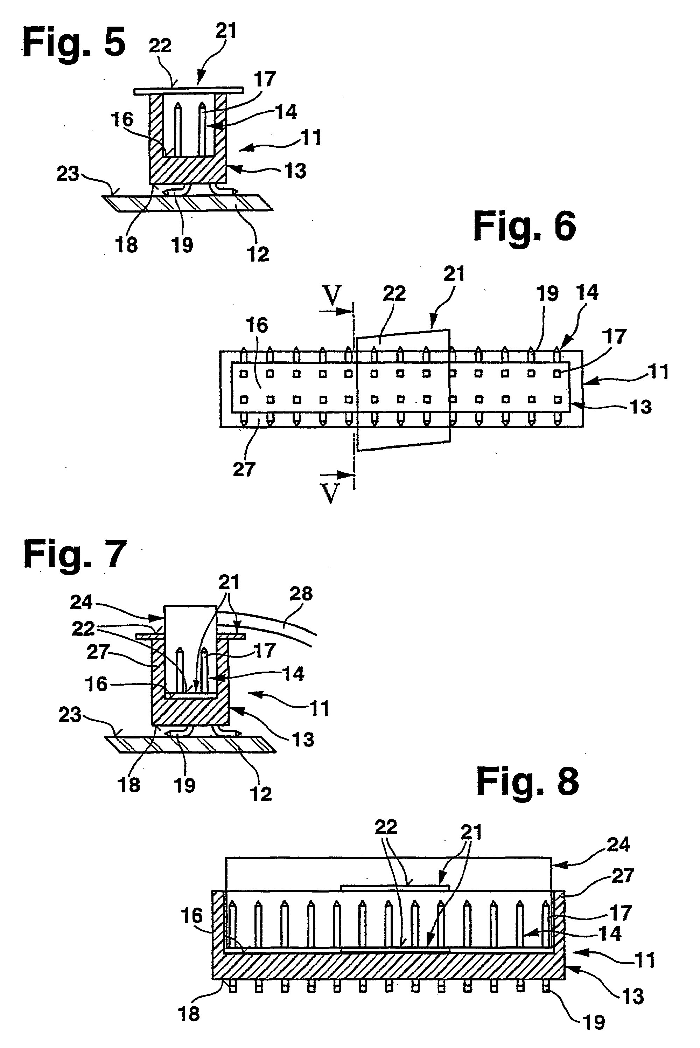

Bei dem in den Figuren 5 bis 8 dargestellten zweiten Ausführungsbeispiel handelt es sich um eine Steckerleiste 11, deren Vorderseite 16 in Abwandlung zum ersten Ausführungsbeispiel einen umlaufenden, die Kontaktabschnitte 17 vertieft einschließenden Kragen 27 aufweist. Auf diesem Kragen 27 ist abschnittsweise mit Überstand der Handhabungskörper 21 in Form einer Folie aus elektrischem Isolierstoff geklebt, der entsprechend der Darstellung in der Figur 6 durchsichtig sein kann.

Der in den Figuren 7 und 8 schematisch dargestellte Gegenstecker 24, hier mit einem Kabelanschluß 28, schert beim Aufstecken auf die Steckerleiste 11, die Überstände des Handhabungskörper 21 ab, und verlagert bei einer weitergeführten Einsteckbewegung den verbleibenden Teil des Handhabungskörpers 21 unter Klemmung entlang der Kontaktabschnitte 17, wobei der Kleberauftrag festhaftend an dem Handhabungskörper 21 verbleibt. Der Abschervorgang kann durch Sollbruchstellen am Handhabungskörper 21 erleichtert werden.

Bei beendetem Aufsteckvorgang liegt der Handhabungskörper 21 an der Vorderseite 16 des Kontaktträgers 13 auf und verbleibt hier selbst bei einem Abziehen des zuvor aufliegenden Gegensteckers 24 lagegesichert durch die Klebeverbindung mit der Vorderseite 16 des Kontaktträgers 13, unterstützt durch die Klemmung des Handhabungskörpers 21 an den Kontaktabschnitten 17. Durch die vernachlässigbare Dicke des Handhabungskörpers 21 ist die Kontaktgabe zwischen Steckerleiste 11 und Gegenstecker 24 nicht gestört.

Somit kann bei beiden Ausführungsbeispielen der Steckerleiste 11 diese in fertigungstechnisch vorteilhafter Weise auf die jeweilige Leiterplatte 12 aufgebracht werden, da die Steckerleiste 11 durch Bestückungsmaschinen zuführbar und in automatisierbarer Produktion verarbeitbar ist.

## Patentansprüche

1. Steckerleiste für die Oberflächenmontage auf einer Leiterplatte, mit einem Kontaktträger (13), in dem vorzugsweise in Reihen angeordnete Kontaktelemente (14) über eine Teillänge eingebettet gelagert sind, die Kontaktelemente (14) freiliegend endseitig einerseits je einen von einer Vorderseite (16) des Kontaktträgers (13) abstehenden Kontaktabschnitt (17) und andererseits je einen von einer Rückseite (18) des Kontaktträgers (13) abstehenden Anschlußabschnitt (19) aufweisen, welcher Anschlußabschnitt (19) zumindest mittelbar mit auf einer Oberseite (23) der Leiterplatte (12) angebrachten Anschluß verbunden wird, **dadurch gekennzeichnet, daß** die Steckerleiste (11) einen Handhabungskörper (21) aufweist, mittels dem die Steckerleiste (11) durch eine Bestückungsvorrichtung erfaßt, der Leiterplatte (12) zugeführt und ausgerichtet auf der Oberseite (23) abgesetzt wird und der Handhabungskörper (21) nach einer stoffschlüssigen Verbindung der Anschlußabschnitte (19) mit den Anschlüssen der Leiterplatte (12) durch einen mit der Steckerleiste (11) koppelbaren Gegenstecker (24) mittels einer mit dem Handhabungskörper (21) korrespondierenden Andrückfläche des Gegensteckers (24) von einer Erfassungsposition in eine Rastposition am Kontaktträger (13) verlagert wird.

2. Steckerleiste nach Anspruch 1, **dadurch gekennzeichnet, daß** der Handhabungskörper (21) als eine Platte ausgebildet, vorzugsweise durch eine Klemm- oder Klebeverbindung mit den freiliegenden Enden der Kontaktabschnitte (17) verbunden ist und eine von den Kontaktabschnitten (17) abgewandte Erfassungsfläche (22) für die Bestückungsvorrichtung aufweist.

3. Steckerleiste nach Anspruch 2, **dadurch gekennzeichnet, daß** der Kontaktträger (13) eine Vertiefung (26) aufweist, in die der Handhabungskörper (21) für die Einnahme der Rastposition eingepreßt wird.

4. Steckerleiste nach Anspruch 1, **dadurch gekennzeichnet, daß** der Handhabungakörper (21) als eine Folie ausgebildet durch eine Klebeverbindung auf einem die Kontaktabschnitte (17) umfassenden Teil (27) des Kontaktträger (13) aufgeklebt ist und eine von den Kontaktabschnitten (17) abgewandte Erfassungsfläche (22) für die Bestückungsvorrichtung aufweist.

5. Steckerleiste nach Anspruch 4, **dadurch gekennzeichnet, daß** der Handhabungskörper (21) einseitig den Klebstoff trägt und in der Rastposition mit der Oberseite (23) der Leiterplatte (12) eine Klebeverbindung eingeht.

## Claims

1. Contact strip for surface mounting on a printed circuit board, with a contact carrier (13), in which contact elements (14), preferably arranged in rows, are mounted such that they are embedded over part of their length, the contact elements (14) have exposed at the ends on one side in each case a contact portion (17) protruding from a front side (16) of the contact carrier (13) and on the other side in each case a connection portion (19) protruding from a rear side (18) of the contact carrier (13), which connection portion (19) is connected at least indirectly to a terminal attached on the upper side (23) of the printed circuit board (12), **characterized in that** the contact strip (11) has a handling body (21), by means of which the contact strip (11) is seized by a pick-and-place device, fed to the printed circuit board (12) and placed in an aligned manner on the upper side (23) and, after integral bonding of the connection portions (19) with the terminals of the printed circuit board (12), the handling body (21) is displaced from a seizing position into a locking position on the contact carrier (13) by a mating connector (24), which can be coupled to the contact strip (11), by means of a pressing area of the mating connector (24) corresponding to the handling body (21).

2. Contact strip according to Claim 1, **characterized in that** the handling body (21) taking the form of a plate is connected to the exposed ends of the contact portions (17), preferably by a clamping connection or adhesive bond, and has a seizing area (22), facing away from the contact portions (17), for the pick-and-place device.

3. Contact strip according to Claim 2, **characterized in that** the contact carrier (13) has a depression (26), into which the handling body (21) is pressed for assuming the locking position.

4. Contact strip according to Claim 1, **characterized in that** the handling body (21) taking the form of a film is adhesively attached on a part (27) of the contact carrier (13) comprising the contact portions (17) by an adhesive bond and has a seizing area (22), facing away from the contact portions (17), for the pick-and-place device.

5. Contact strip according to Claim 4, **characterized in that** the handling body (21) carries the adhesive on one side and, in the locking position, enters into an adhesive bond with the upper side (23) of the printed circuit board (12).

## Revendications

1. Barrette de connexion pour la technique de montage de composants en surface sur un circuit imprimé comprenant un support de contact (13) muni d'éléments de contact (14) de préférence répartis en rangée et qui sont intégrés dans ce support sur une partie de leur longueur, les éléments de contact (14) étant dégagés d'un côté en formant chacun un segment de contact (17) en saillie de la face avant (16) du support de contact (13) et de l'autre côté, un segment de branchement (19) en saillie de la face arrière (18) du support de contact (13), le segment de branchement (19) étant relié au moins indirectement à un moyen de branchement prévu sur la face supérieure (23) du circuit imprimé (12),
**caractérisée en ce que**
la barrette de contact (11) comporte un organe de manipulation (21) à l'aide duquel la barrette de connexion (11) peut être saisie par un dispositif de garnissage, pour être conduite sur le circuit imprimé (12) et être déposée de manière alignée sur sa face supérieure (23) et
après avoir réalisé la liaison par de la matière entre les segments de branchement (19) et les éléments de branchement du circuit imprimé (12), l'organe de prise (21) est déplacé à l'aide d'un connecteur complémentaire (24) et couplé à la barrette de connexion (11), par une surface de poussée du connecteur complémentaire (24) qui correspond à l'organe de prise (21), pour passer d'une position de prise à une position de repos contre le support de contact (13).

2. Barrette de connexion selon la revendication 1,
**caractérisée en ce que**
l'organe de prise (21) est une plaque de préférence reliée aux extrémités libres des segments de contact (17) par une liaison par serrage ou collage et cette plaquette présente du côté opposé aux segments de contact (17), une surface de prise (22) pour les dispositifs de garnissage.

3. Barrette de connexion selon la revendication 2,
**caractérisée en ce que**
le support de contact (13) comporte une cavité (26) dans laquelle on presse l'organe de manipulation (21) pour lui faire prendre sa position de repos.

4. Barrette de connexion selon la revendication 1,
**caractérisée en ce que**
l'organe de manipulation (21) est constitué par un film collé par une liaison collée sur une partie (27) du support de contact (13) entourant les segments de contact (17) et ce film présente du côté opposé aux segments de contact (17), une surface de prise (22) pour le dispositif de garnissage.

5. Barrette de connexion selon la revendication 4,
**caractérisée en ce que**
l'organe de manipulation (21) est muni de colle sur une face et en position de repos il réalise une liaison collée avec la face supérieure (23) du circuit imprimé (12).
